# EUROPEAN PATENT APPLICATION

(11) **EP 1 496 729 A2**
(43) Date of publication of application: **12.01.2005**
(21) Application number: 04103306.9
(22) Date of filing: 12.07.2004
(51) Int. Cl.: H05K 3/00, H05K 1/02, H05K 7/20

(54) **Method of assembling a printed circuit to a support**

(30) Priority: 10.07.2003 IT MO20030200
(71) Applicant: NUOVA LAELVI S.r.l. Società Unipersonale, 15058 VIGUZZOLO (IT)
(72) Inventor: Tognella, Alberto, 41100, MODENA (IT)
(74) Representative: Jorio, Paolo

(57) **Abstract**

There is described a method of assembling a printed circuit to a support, in particular to a dissipator. First, a printed circuit (10; 10'; 10''), and a support (20) having at least one main face (20a) by which to engage the printed circuit (10; 10'; 10''), are prepared. An intermediate layer (30) made of glass fibre impregnated with epoxy resin, and having a first face (30a) and an opposite second face (30b), is then positioned between the printed circuit (10; 10'; 10'') and the main face (20a) of the support (20). And finally, the first face (30a) of the intermediate layer (30) is placed in contact with the printed circuit (10; 10'; 10"), the second face (30b) of the intermediate layer (30) is placed in contact with the main face (20a) of the support (20), and the printed circuit (10; 10'; 10"), the intermediate layer (30), and the support (20) are then pressed together.

## Description

The present invention relates to a method of assembling a printed circuit to a support, in particular, to a dissipator.

As is known, during operation, the electronic components mounted on printed circuits to form a given electronic circuit dissipate quantities of heat - typically produced by the Joule effect - depending on the operating currents and voltages of the circuit. When the heat produced by the electronic components becomes excessive, malfunctioning, breakdowns, etc. may occur, so printed circuits are normally provided with dissipators to dissipate the heat produced during operation of the circuit and so prevent damage to the circuit.

Commonly used dissipators comprise a three-layer laminate having a first copper layer, a second intermediate kapton layer, and a third aluminium layer; and the laminate is fixed, normally glued, to the bottom surface of the printed circuit, i.e. to the surface opposite the one on which the solder and tin-lead are deposited, so that the heat produced by the electronic circuit components is at least partly dissipated by the aluminium layer.

A major drawback of this type of dissipator lies in the kapton layer, used to electrically insulate the circuit and the aluminium layer of the dissipator, preventing large part of the heat produced by the circuit from reaching the aluminium layer, and so impairing dissipation by the aluminium layer. As a result, the printed circuit may reach extremely high temperatures, which, besides creating circuit problems, may also have negative effects on the glue, thus resulting in detachment of the dissipator from the printed circuit.

It is an object of the present invention to eliminate the aforementioned drawbacks.

In particular, it is an object of the present invention to provide a method of assembling a printed circuit to a support, in particular a dissipator, which provides for effectively dissipating in-service heat produced by the electronic circuit, thus reducing the maximum temperature reached by the printed circuit.

It is a further object of the present invention to provide a method ensuring the dissipator is fixed firmly and irremovably to the printed circuit, even in the presence of considerable heat produced by the electronic circuit components.

It is a further object of the present invention to provide a method enabling printed circuits to be assembled to exceptionally thick dissipators, even of a few centimetres in thickness.

It is a further object of the present invention to provide a method enabling the dissipator to be fixed to both one-sided, two-sided, and multilayer single SMT printed circuits.

These and other objects are substantially achieved by the method of assembling a printed circuit to a support, in particular a dissipator, as claimed in the accompanying Claims.

A preferred, non-limiting embodiment of a method of assembling a printed circuit to a support, in particular a dissipator, will be described by way of example with reference to the accompanying drawings, in which:
Figures 1, 2 and 3 show, schematically, steps in the method according to the present invention;
Figure 4 shows an end product of the method in Figures 1, 2 and 3;
Figures 5 and 6 show variations of the method in Figures 1, 2 and 3.

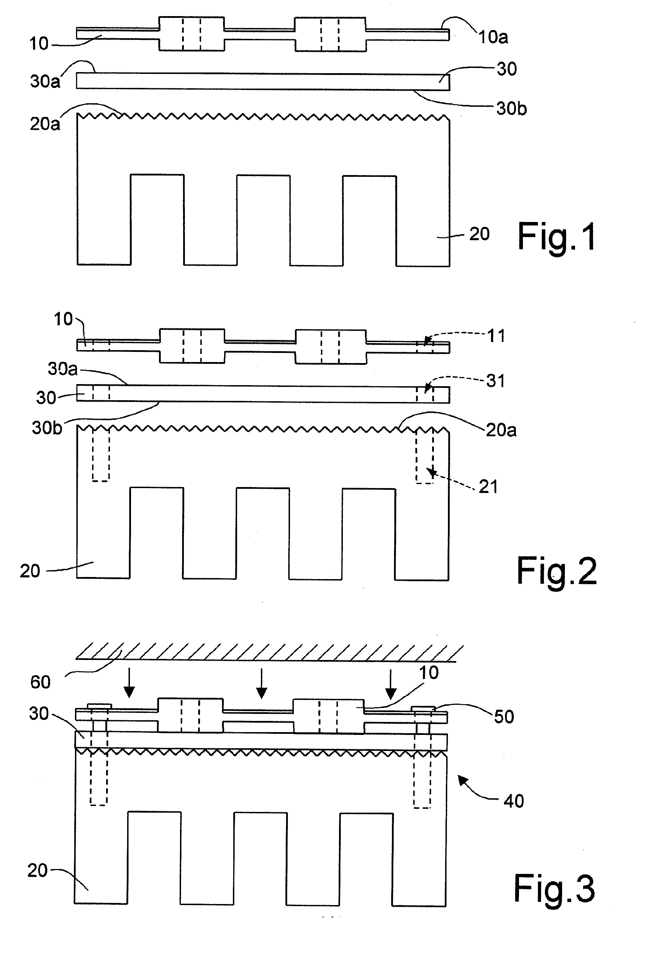

With reference to Figure 1, the method according to the present invention first comprises a step of preparing a printed circuit 10, which may, for example, be a single SMT type, and which comprises a face 10a coated with solder and to which tin-lead has been applied using a hot air levelling technique.

The method also comprises the step of preparing a support 20, preferably made of metal, in particular aluminium. Support 20 may conveniently be a dissipator, i.e. an element for dispersing heat produced by the devices mounted on the printed circuit; and dissipator 20 may be of various forms, depending on specific requirements. In one typical embodiment (shown schematically in the accompanying drawings), dissipator 20 may comprise a number of tabs connected to a platelike base to maximize the surface in contact with the air and so optimize heat dissipation.

To assemble printed circuit 10 to support 20, the method comprises the step of interposing between them an insulating intermediate layer 30, preferably made of glass fibre impregnated with a preferably 50% catalyzed epoxy resin. As will become clearer later on, intermediate layer 30, which comprises a first face 30a and an opposite second face 30b, serves to fix support 20 irremovably to printed circuit 10.

To ensure firm connection of intermediate layer 30 to support 20, support 20 is subjected to a number of processing operations.

First of all, a main face 20a of support 20 (i.e. the face eventually contacting intermediate layer 30) is surface processed to increase the contact surface between intermediate layer 30 and main face 20a. More specifically, main face 20a is dulled and roughened by abrasion, either manually (e.g. using sandpaper) or on appropriate machines (e.g. brushing machines). Main face 20a of support 20 is then degreased using a 10% caustic soda solution, and is further cleaned with trichloroethylene or acetone to remove any previous processing residue which may impair adhesion between main face 20a and second face 30b of intermediate layer 30.

With reference to Figures 2 and 3, the method according to the present invention also provides for temporary mechanical connection of printed circuit 10, intermediate layer 30, and support 20, before they are eventually fixed irremovably. More specifically, temporary mechanical connection serves to keep the various layers 10, 30, 20 positioned correctly when performing the basic assembly steps as described in detail later on.

To make the above temporary mechanical connection, a first through hole 31 is formed in intermediate layer 30 (Figure 2); a second hole 21 is formed in support 20, and comes out at main face 20a; and a third hole 11 is formed in printed circuit 10. At least one of second and third holes 21, 11 is a through hole, and even both may be through holes.

Printed circuit 10, intermediate layer 30, and support 20 are then positioned so that first, second, and third holes 31, 21, 11 are substantially coaxial. More specifically, first face 30a of intermediate layer 30 is placed contacting printed circuit 10 (more specifically, contacting the face opposite face 10a on which the solder has been deposited), and second face 30b of intermediate layer 30 is placed contacting main face 20a of support 20, so that printed circuit 10, intermediate layer 30, and support 20 define a main body 40 shown schematically in Figure 3.

A fastening member 50, e.g. a stainless steel screw or pin, is then inserted inside first, second, and third holes 31, 21, 11 to connect printed circuit 10, intermediate layer 30, and support 20.

If a screw is used, the head of the screw is advantageously flat to prevent epoxy resin leakage (from intermediate layer 30) when the resin is melted to assemble printed circuit 10 to support 20, as explained later on. Moreover, silicone is conveniently interposed between fastening member 50 and the layers into which it is inserted, to prevent the resin from also coming into contact with fastening member 50 and so securing it irremovably to layers 10, 30, 20. When assembly is completed, in fact, fastening member 50 is normally removed.

It should be pointed out that, though reference is made here to one hole per layer, a number of holes may be formed in each layer, and a number of fastening members 50 may be used to ensure the layers are maintained in position even more reliably.

Once printed circuit 10, intermediate layer 30, and support 20 are connected by fastening member 50, the method according to the invention provides for hot pressing the resulting main body 40 using a press platen 60. More specifically, main body 40 is pressed at a temperature ranging between 140°C and 160°C, and preferably of 150°C.

The epoxy resin in intermediate layer 30 is thus at least partly melted, and adheres to printed circuit 10 at first face 30a, and to main face 20a of support 20 at second face 30b. More specifically, the molten resin fills all the more or less large cavities formed on, and by abrading, main face 20a of support 20, thus resulting in an extensive contact area between intermediate layer 30 and support 20.

The method then provides for controlled cooling of main body 40, which, in the space of about 10-20 minutes is cooled to a temperature of about 50°C. It is important that cooling be performed gradually to avoid problems, in particular mechanical strain and stress, caused by the difference in the behaviour of the materials of printed circuit 10 and support 20 alongside variations in temperature. Again to prevent undesired strain, the method may provide for preheating printed circuit 10 for several hours (e.g. for a whole night) to about 80°C, before commencing assembly to support 20, in particular, the hot pressing step.

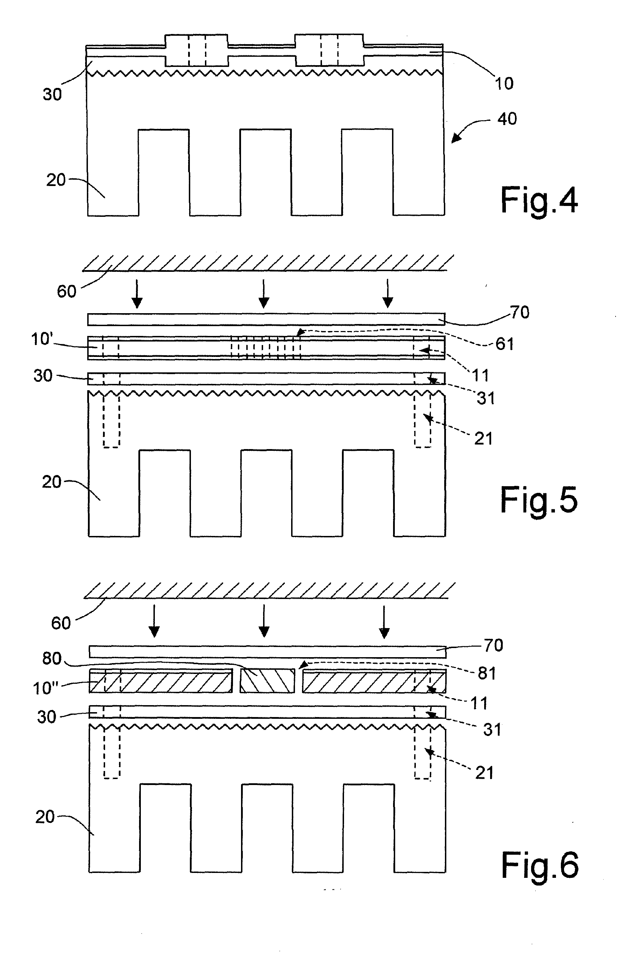

Once main body 40 is cooled, the final steps in the method may be performed, and which comprise removing fastening member 50 (or the fastening members, if more than one is used), which is made possible by the layer of silicone surrounding fastening member 50 to isolate it from the epoxy resin, and removing any resin expelled laterally by the heating and pressing steps, to obtain the finished product shown schematically in Figure 4.

The method according to the present invention has important advantages. In particular, connection of the support (in particular, the dissipator) to the printed circuit is extremely firm and reliable, even in the presence of considerable heat produced by the components mounted on the printed circuit.

Moreover, by virtue of the processing operations and the steps in the method described above, dissipation is greatly improved as compared with the known state of the art, so that the printed circuit may even be fitted, for example, with high-density LEDs, which may reach operating temperatures of 120-130°C, without the temperature of the printed circuit exceeding 60°C.

Since the supports, as opposed to being laminated, are simply in the form of metal members connected to the printed circuit as described above, another advantage lies in the printed circuit being connectable to exceptionally thick supports (dissipators), even of about ten centimetres in thickness.

Another advantage lies in the assembly method according to the present invention also applying to both one-sided, two-sided, and multilayer single SMT printed circuits.

Clearly, changes may be made to what described and illustrated herein without, however, departing from the scope of the present invention as defined in the accompanying Claims.

In particular (Figure 5), in the case of two-sided printed circuits 10', metalized through holes 61 are normally formed to improve heat passage to dissipator 20 underneath, and are normally located at the electronic components generating most heat, e.g. at a silicon power LED. In which case, to prevent the epoxy resin in intermediate layer 30 from leaking from metalized holes 61 at the pressing step, and so impairing soldering of the electronic components, one aspect of the method according to the invention provides for vacuum applying a release film 70 between printed circuit 10' and press platen 60. More specifically, release film 70 is made, for example, of PVC, is resistant to temperatures of up to 250°C, and provides for sealing metalized holes 61.

In the case of one-sided printed circuits 10" (Figure 6), another aspect of the method, again to improve heat passage to dissipator 20, provides for placing a copper pellet 80 at the hottest points of printed circuit 10", e.g. at high-power silicon LEDs. More specifically, copper pellet 80 is housed inside a through hole 81 formed in printed circuit 10", and is the same thickness as printed circuit 10", so as to effectively conduct the heat generated by the circuit to dissipator 20 underneath. At the pressing step, copper pellet 80 is secured irremovably to intermediate layer 30. In this case too, the method provides for vacuum applying a release film 70 between printed circuit 10" and press platen 60, to prevent resin leakage from the portions of hole 81 not engaged by copper pellet 80.

## Claims

1. A method of assembling a printed circuit to a support, in particular a dissipator, comprising the steps of:
- preparing a printed circuit (10; 10'; 10");
- preparing a support (20) having at least one main face (20a) by which to engage said printed circuit (10; 10'; 10");
- positioning an intermediate layer (30) between said printed circuit (10; 10'; 10") and the main face (20a) of said support (20); the intermediate layer having a first face (30a) and an opposite second face (30b); and said printed circuit (10; 10'; 10"), said intermediate layer (30), and said support (20) defining a main body (40) ;
- placing the first face (30a) of said intermediate layer (30) in contact with said printed circuit (10; 10'; 10"), and the second face (30b) of said intermediate layer (30) in contact with the main face (20a) of said support (20); and
- pressing together said printed circuit (10; 10'; 10"), said intermediate layer (30), and said support (20).

2. A method as claimed in Claim 1, wherein said step of preparing a support (20) comprises the step of surface processing said support (20); said surface processing comprising, in particular, an abrasion step to abrade said main face (20a).

3. A method as claimed in Claim 1 or 2, wherein said support (20) is a heat dissipator preferably made of metal, and in particular of aluminium.

4. A method as claimed in any one of the foregoing Claims, wherein said step of preparing a support (20) comprises a step of degreasing said main face (20a), preferably by applying a caustic soda solution to said main face (20a).

5. A method as claimed in any one of the foregoing Claims, wherein said step of preparing a support (20) comprises a step of cleaning said main face (20a), preferably by applying trichloroethylene or acetone to said main face (20a).

6. A method as claimed in any one of the foregoing Claims, wherein said step of preparing a support (20) comprises successive steps of: surface processing said support (20); degreasing said main face (20a); and cleaning said main face (20a).

7. A method as claimed in any one of the foregoing Claims, wherein said intermediate layer (30) is made of insulating material, in particular of glass fibre impregnated with an epoxy resin; said epoxy resin preferably being 50% catalyzed.

8. A method as claimed in any one of the foregoing Claims, wherein said pressing step comprises a heating step to heat said main body (40), preferably to a temperature ranging between 140°C and 160°C, and in particular of 150°C.

9. A method as claimed in any one of the foregoing Claims, and also comprising a cooling step to cool said main body (40), preferably to a temperature of 50°C in a time interval of 10 to 20 minutes; said cooling step being performed after said pressing step.

10. A method as claimed in any one of the foregoing Claims, wherein said step of placing the first and second faces of the intermediate layer in contact with the printed circuit and the main face of the support comprises a connecting step to mechanically connect said printed circuit (10; 10'; 10"), said intermediate layer (30), and said support (20).

11. A method as claimed in Claim 10, **characterized in that** said connecting step comprises the steps of:
- forming at least one first through hole (31) in said intermediate layer (30);
- forming a second hole (21) in the main face (20a) of said support (20);
- forming a third hole (11) in said printed circuit (10; 10'; 10"); at least one of said second and third holes (21, 11) being a through hole;
- positioning said printed circuit (10; 10'; 10"), said intermediate layer (30), and said support (20) so that said first, second, and third holes (31, 21, 11) are substantially coaxial; and
- inserting a fastening member (50) inside said first, second, and third holes (31, 21, 11); the fastening member preferably being defined by a screw or pin.

12. A method as claimed in Claim 11, and also comprising a step of removing said fastening member (50) after said pressing step.

13. A method as claimed in any one of the foregoing Claims, wherein said pressing step is performed using a press platen (60); said method also comprising the step of positioning a release film (70) between said printed circuit (10; 10'; 10") and said press platen (60) prior to said pressing step.

14. A method as claimed in any one of the foregoing Claims, wherein said step of preparing a printed circuit (10; 10'; 10") comprises the steps of forming a through hole (81) at at least one point on said printed circuit (10; 10'; 10"); and inserting a block (80) of heat-conducting material, in particular of copper, inside said through hole (81); said block (80), in particular, being the same thickness as said printed circuit (10; 10'; 10'').
